Europäisches Patentamt

European Patent Office

Office européen des brevets

(11) Veröffentlichungsnummer: **0 498 252 A2**

(12) **EUROPÄISCHE PATENTANMELDUNG**

(21) Anmeldenummer: **92101274.6**

(22) Anmeldetag: **27.01.92**

(51) Int. Cl.⁵: **G11C 8/00**

(30) Priorität: **04.02.91 DE 4103309**

(43) Veröffentlichungstag der Anmeldung:
**12.08.92 Patentblatt 92/33**

(84) Benannte Vertragsstaaten:
**AT CH FR GB IT LI**

(71) Anmelder: **MIKROELEKTRONIK UND
TECHNOLOGIE GESELLSCHAFT mbH**
Grenzstrasse 28, PF 34
O-8080 Dresden(DE)

(72) Erfinder: **Dathe, Lutz, Dipl.-Ing.**
Hermann-Duncker-Strasse 25
0-7113 Markkleeberg(DE)
Erfinder: **Krauss, Mathias, Dr. sc. techn.**
Röthenbacher Strasse 21
0-8027 Dresden(DE)

(54) Schaltungsanordnung zur Ansteuerung von Wortleitungen in Halbleiterspeichern.

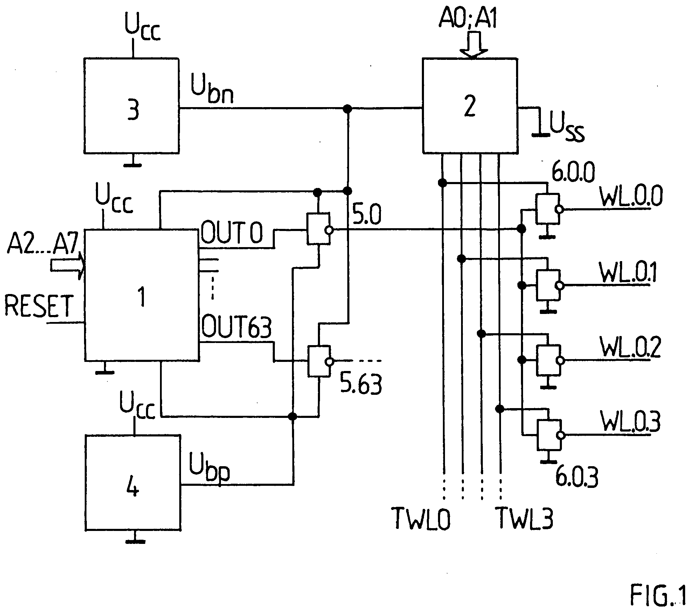

(57) Die Erfindung löst die Aufgabe, in Halbleiterspeichern, in denen die Wortleitungen zur Vermeidung doppelt überhöhter Spannungsknoten mit einer statisch überhöhten Spannung angesteuert werden, die Entladung / das Halten nichtangewählter Wortleitungen auf Massepotential ohne gesonderte Entladetransistoren und deren Ansteuereinrichtungen zu ermöglichen. Die Schaltungsanordnung (gemäß Fig. 1) enthält einen Spannungsgenerator (3) für eine n-Wannen-Spannung ($U_{bn}$), einen zwischen der n-Wannen-Spannung ($U_{bn}$) und Massepotential ($U_{ss}$) angeordneten Wortleitungstaktdekoder (2) mit m Eingängen und $2^m$, Wortleitungstakte (TWLm) führende Ausgänge, einen ebenfalls an der n-Wannen-Spannung ($U_{bn}$) angeschlossenen Adreßdekoder (2) mit n Eingängen, einem Rücksetzeingang sowie $2^n$ Ausgängen, und $2^n$ Gruppen zu je $2^m$ Wortleitungsnegatoren (6.m.n), deren Eingänge jeweils gruppenweise miteinander verbunden über jeweils einen mit einem Versorgungsspannungsanschluß an der n-Wannen-Spannung ($U_{bn}$) liegenden Entkoppelnegator (5.i) an den Ausgängen des Adreßdekoders (2) angeschlossen sind, wobei der jeweils erste Versorgungsspannungsanschluß jedes Wortleitungsnegators (6.m.n) einer Gruppe mit einem der Ausgänge des Wortleitungstaktdekoders (2) verbunden sowie die Ausgänge der Wortleitungsnegatoren (6.m.n) auf die Wortleitungen des Speichers geführt sind.

Erfindungsgemäß ist ein zweiter, zwischen Versorgungsspannung ($U_{cc}$) und Massepotential ($U_{ss}$) angeordneter Spannungsgenerator (4), dessen Ausgang eine gegenüber dem Massepotential ($U_{ss}$) verringerte p-Wannen-Spannung ($U_{bp}$) führt, vorgesehen und diese p-Wannen-Spannung ($U_{bp}$) auf die jeweils zweiten Versorgungsspannungsanschlüsse des Adreßdekoders (1) sowie der Entkoppelnegatoren (5.i) gelegt.

Die Erfindung ist insbesondere in hochintegrierten dRAM und sRAM, die in CMOS-Technologie gefertigt werden, einsetzbar.

FIG.1

Die Erfindung betrifft eine Schaltungsanordnung zur Ansteuerung von Wortleitungen in Halbleiterspeichern nach dem Oberbegriff des Patentanspruches 1, welche insbesondere in hochintegrierten Speichern, die in CMOS-Technologie gefertigt werden, einsetzbar ist und zum Halten des Massepotentials auf nichtangesteuerten Wortleitungen dient.

Zur Ansteuerung von Wortleitungen in Halbleiterspeichern sind verschiedene Schaltungen bekannt.

So ist in der EP-Anm. 179 651 eine Schaltung zur Wortleitungsansteuerung in statischen Schreib-Lese-Speichern beschrieben, welche einen Adreßdekoder und einen Wortleitungstaktdekoder verwendet, an welchen die Wortadressen anliegen. Die low-aktiven Ausgänge des Adreßdekoders sind jeweils auf Wortleitungsnegatoren geführt, deren Versorgungsanschlüsse bei Blockauswahl durch den Wortleitungstaktdekoder mit einer Wortleitungsspannung versorgt werden. Zur Entladung nichtangewählter Wortleitungen ist jeder Wortleitung ein Entladetransistor zugeordnet, der jeweils von einem zusätzlichen Steuersignal angesteuert ist.

Bei der Wortleitungsansteuerung in dynamischen Halbleiterspeichern ergibt sich jedoch das Problem, daß der Schwellspannungsabfall über den Transistoren der Speicherzellen die in den Speicher eingeschriebenen Ladungen vermindert. Dieser Abfall beeinträchtigt das weitere ordnungsgemäße Auslesen der Daten.

Um ein vollständiges Einschreiben bzw. Auslesen der Speicherzelle zu ermöglichen, werden die Wortleitungen im allgemeinen mit einer Spannung angesteuert, die höher als die Versorgungsspannung des Speichers ist.

Zur Überhöhung der Wortleitungsspannung sind verschiedene Ausführungsformen von Boosterschaltungen bekannt, die die Wortleitungsspannung kapazitiv nachschieben.

Wird dabei die Wortleitungsspannung während des gesamten Speicherzyklus überhöht, so werden die Transistoren sehr belastet. Dies wird in der Lösung nach WO-Anm. 86/04 726 vermieden, indem die erhöhte Spannung zu Beginn des Speicherzyklus angelegt, im mittleren Zyklusteil wieder auf den Wert der Versorgungsspannung abgesenkt und in der Refresh-Phase wieder überhöht wird.

Bekanntermaßen werden in Wortleitungstaktdekodern beispielsweise zwei in Reihe geschaltete Transistoren des gleichen Leitfähigkeitstyps eingesetzt, die zwischen Massepotential und der gegenüber der Versorgungsspannung überhöhten Spannung angeordnet sind und wobei zwischen beiden Transistoren als Ausgang die Taktspannung anliegt. Dabei liegen am Gate eines Transistors abwechselnd Massepotential und eine gegenüber der zur Versorgungsspannung überhöhten Spannung nochmals überhöhte Spannung, die das Doppelte der Versorgungsspannung betragen kann. Diese nochmals überhöhte Spannung erreicht die Größenordnung der Durchbruchspannung zwischen Substrat und den Diffusionsgebieten, so daß die Gefahr von Spannungsdurchbrüchen immanent ist.

Zur Vermeidung solcher doppelt überhohten Spannungsknoten wurde bereits vorgeschlagen, die Wortleitungsspannung nicht mehr durch eine dynamisch überhöhte Spannung zu gewinnen, sondern eine im Speicher bereitgestellte statische Spannung zu verwenden.

Dabei liegt die überhöhte Spannung, welche als n-Wannen-Spannung geführt ist, an einem Wortleitungstaktdekoder an, dessen Eingänge erste Wortadressen führen. Entsprechend den anliegenden Adressen besitzt einer seiner Ausgänge einen überhöhten Pegel, die anderen low-Pegel. Alle Ausgänge sind jeweils mit Versorgungsspannungsanschlüssen von Wortleitungsnegatoren verbunden, deren Ausgänge wiederum die Wortleitungen bilden. Im weiteren enthält die Schaltung einen high-aktiven Adreßdekoder, dessen Ausgänge mit jeweils einem Entkoppelnegator verbunden sind, deren Ausgänge wiederum auf die verbundenen Eingänge jeweils einer Gruppe von vier Wortleitungsnegatoren gelegt sind. In jeder dieser Gruppe ist jeweils ein Ausgang des Wortleitungstaktdekoders mit einem Versorgungsspannungsanschluß eines Wortleitungsnegators verbunden.

An jede Wortleitung ist noch ein nMOS-Entladetransistor angeschlossen, an dessen Gate der zugehörige negierte Ausgang des Wortleitungstaktdekoders anliegt, um die nichtangesteuerten Wortleitungen auf low-Potential zu halten.

Nachteilig ist hierbei der erhöhte schaltungstechnische Aufwand in Form der Entladetransistoren und der Realisierung der zusätzlichen Steuersignale für dieselben, insbesondere durch die Anordnung im Bereich des Wortleitungsrasters.

Der Erfindung liegt die Aufgabe zugrunde, eine Schaltungsanordnung anzugeben, welche in Halbleiterspeichern, in denen die Wortleitungen zur Vermeidung doppelt überhöhter Spannungsknoten mit einer statisch überhöhten Spannung angesteuert werden, die Entladung bzw. das Halten nichtangewählter Wortleitungen auf Massepotential unter Vermeidung gesonderter Entladetransistoren und deren Ansteuereinrichtungen ermöglicht, so daß sich der schaltungstechnische Aufwand verringert.

Erfindungsgemäß wird die Aufgabe durch eine Schaltungsanordnung mit den Merkmalen des Patentanspruches 1 gelöst.

Zur Beschreibung der Wirkungsweise dieser Schaltungsanordnung sollen als Ausgangszustand die Wortleitungsadressen einer gewählten Adreßkombination inaktiv sein.

Durch ein aktives Rücksetzsignal am Rücksetzeingang des Adreßdekoders wird das Potential an dem der Adreßkombination zugehörigen Ausgang vom Wert der n-Wannen-Spannung auf den der p-Wannen-Spannung gezogen, d. h. das der Adreßkombination zugeordnete Flipflop im Adreßdekoder kippt.

Damit schaltet der zugehörige Entkoppelnegator auf das Potential der n-Wannen-Spannung und die m angewählten Wortleitungsnegatoren auf Massepotential um, so daß die angewählten Wortleitungen mit dem Massepotential verbunden sind.

Bei Anlegen einer vorab festgelegten Adreßkombination wird nun der zugehörige Ausgang des Adreßdekoders auf den Wert der n-Wannen-Spannung aufgeladen. Der Ausgang des zugehörigen Entkoppelnegators führt danach das Potential der p-Wannen-Spannung, wodurch die Verbindung der angesteuerten Wortleitungen über die Wortleitungsnegatoren mit Massepotential unterbrochen wird. Der jeweils aktivierte Wortleitungstakt lädt dann über den entsprechenden Wortleitungsnegator die ausgewählte Wortleitung auf.

Die Entladung der nichtangewählten Wortleitungen auf Massepotential wird nun dadurch ermöglicht, daß die nicht angesprochenen Wortleitungsnegatoren mit einer Spannung angesteuert werden, deren low-Pegel kleiner als das Massepotential ist. Durch die negative Ansteuerung werden diese Wortleitungen über die an den Wortleitungstakten angeschlossenen p-Kanal-Transistoren der Wortleitungsnegatoren und die auf Masse liegenden, inaktiven Wortleitungstakte entladen.

Damit benötigt die Schaltung keine Entladetransistoren für die Wortleitungen samt deren Ansteuerungen, so daß der zusätzliche Aufwand im Adreßdekoder, der vor allem das Wortleitungsraster belastet, entfällt.

Weitere vorteilhafte Ausgestaltungen der Erfindung ergeben sich aus den Patentansprüchen 2 bis 6. Dabei ist die Schaltungsanordnung nach Anspruch 6 für den Einsatz in statischen RAM-Speichern konzipiert.

Die Erfindung sei nunmehr in einem Ausführungsbeispiel anhand zweier Zeichnungen näher erläutert.

Dabei zeigen:

Fig. 1　　eine Blockdarstellung der erfindungsgemäßen Schaltungsanordnung für einen dRAM

Fig. 2　　einen Stromlaufplan der Ansteuerung einer Wortleitung zu Fig. 1.

Die als Blockdarstellung in Fig. 1 gezeigte erfindungsgemäße Schaltungsanordnung enthält zunächst einen Adreßdekoder 1, der an einer Versorgungsspannung $U_{cc}$ und Massepotential $U_{ss}$ angeschlossen ist, sowie einen Wortleitungstaktdekoder 2, dessen einer Versorgungsanschluß an Massepotential $U_{ss}$ liegt. Auf den Wortleitungstaktdekoder 2 sind die Wortleitungsadressen AO; A1 sowie auf den Adreßdekoder 1 die Wortleitungsadressen A2...A7 und zusätzlich ein Rücksetzsignal RESET auf einen gesonderten Rücksetzeingang geführt.

Der Wortleitungstaktdekoder 2 besitzt damit 4 Ausgänge mit Wortleitungstakten TWL0...TWL3, der Adreßdekoder 63 Ausgänge OUT0...OUT63.

Weiterhin sind ein erster Spannungsgenerator 3, an dessem Ausgang eine n-Wannen-Spannung $U_{bn}$ abgegeben wird, die gegenüber der Versorgungsspannung $U_{cc}$ um eine Schwellspannung $U_{tn}$ eines nMOS-Transistors und weitere 0,5...1 V erhöht ist, sowie ein zweiter Spannungsgenerator 4, an dessem Ausgang eine p-Wannen-Spannung $U_{bp}$ abgegeben wird, die gegenüber Massepotential $U_{ss}$ um eine Schwellspannung $U_{tp}$ eines pMOS-Transistors und weitere 0,5...1 V verringert ist, vorgesehen. Die beiden Spannungsgeneratoren sind jeweils zwischen der Versorgungsspannung $U_{cc}$ und Massepotential $U_{ss}$ angeordnet.

Die Erzeugung der n- bzw. p-Wannen-Spannung $U_{bn}$ bzw. $U_{bp}$ in den Spannungsgeneratoren 3 bzw. 4, üblicherweise vermittels Ringoszillator und Pumpschaltung, ist allgemein bekannt und soll hier nicht weiter erläutert werden.

Die n-Wannen-Spannung $U_{bn}$ ist nun auf den zweiten Versorgungsspannungsanschluß des Wortleitungstaktnegators 2 sowie einen Referenzanschluß des Adreßdekoders 1; die p-Wannen-Spannung $U_{bp}$ auf einen zweiten Referenzanschluß des Adreßdekoders 1 gelegt. Die n-Wannen-Spannung $U_{bn}$ gilt im übrigen für alle pMOS-Transistoren und die p-Wannen-Spannung $U_{bp}$ für alle nMOS-Transistoren der Schaltungsanordnung.

Die Ausgänge OUT0...OUT63 des Adreßdekoders 1 sind über jeweils einen Entkoppelnegator 5.0...5.63, die mit ihren Versorgungsspannungsanschlüssen an der n- und p-Wannen-Spannung $U_{bn}$; $U_{bp}$ liegen, auf die gruppenweise miteinander verbundenen Eingänge von 64 Gruppen zu je 4 Wortleitungsnegatoren 6.0.0...6.63.3 geführt. Der erste Versorgungsspannungsanschluß jedes Wortleitungsnegators 6.i.0...6.i.3 (mit i = 0...63) einer Gruppe ist am zugehörigen Wortleitungstakt TWL0...TWL3 angeschlossen, die zweiten Versorgungsspannungsanschlüsse sind mit Massepotential $U_{ss}$ verbunden. Die Ausgänge der Wortleitungsnegatoren 6.0.0...6.63.3 sind auf die Wortleitungen WL0.0...WL63.3 gelegt.

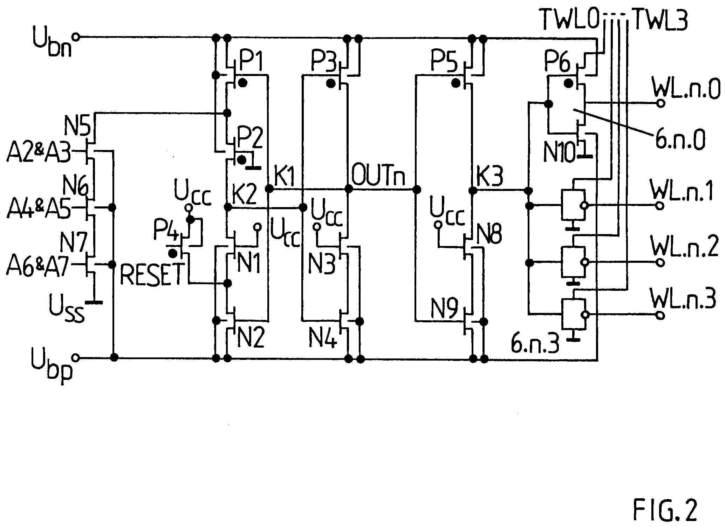

Die Schaltungsanordnung ist parallel hierzu in Fig. 2 als Transistorbild gezeigt.

Dabei wird vom Adreßdekoder 1 der Übersichtlichkeit halber nur der n-te Teil, d. h. die Adreßverknüpfung ausgewählter Adressen zu einem Ausgang OUTn in einem Block, dargestellt.

Jeder dieser Blöcke des Adreßdekoders enthält eine erste Reihenschaltung von zwei pMOS-Transistoren P1; P2 und zwei nMOS-Transistoren N1; N2 sowie eine zweite Reihenschaltung eines pMOS-Transistors P3 mit zwei nMOS-Transistoren N3; NA, welche jeweils zwischen der n-Wannen-Spannung $U_{bn}$ und der p-Wannen-Spannung $U_{bp}$ angeordnet sind.

Die genannten Transistoren sind so verschaltet, daß die miteinander verbundenen Gates der Transistoren P1; N2 und die Drainverbindung der Transistoren P3; N3 einen Knoten K1 sowie die miteinander verbundenen Gates der Transistoren P3; N4 und die Drainverbindung der Transistoren P2; N1 einen Knoten K2 bilden. Das Gate des Transistors P2 ist auf Massepotential $U_{ss}$ und das Gate des Transistors N1 auf das Potential der Versorgungsspannung $U_{cc}$ gelegt.

Zwischen der Drain-Source-Verbindung der Transistoren P1; P2 und Massepotential $U_{ss}$ ist eine Reihenschaltung dreier nMOS-Transistoren N5; N6; N7 angeordnet, an denen die vorverknüpften high-aktiven Wortadressen A2&A3; A4&A5; A6&A7 in wahrer oder negierter Form anliegen. Von der Drain-Source-Verbindung der Transistoren N1; N2 ist ein pMOS-Transistor P4 gegen die Versorgungsspannung $U_{cc}$ geschaltet, an dessen Gate ein low-aktives Rücksetzsignal RESET gelegt ist. Dabei ist die Impedanz des Transistors P4 wesentlich geringer als die Impedanz des Transistors N2.

Die beiden Reihenschaltungen sind somit zu einem Flipflop verschaltet, bei dem der Knoten K1 entsprechend der Kombination der sechs Wortadressen A2...A7 einen Ausgang OUTn (n = 0...63) realisiert.

Der Knoten K1 ist weiterhin mit den verbundenen Gates eines pMOS-Transistors P5 und eines nMOS-Transistors N9 verbunden, welche mit einem zwischen ihren angeordneten nMOS-Transistor N8, dessen Gate an die Versorgungsspannung $U_{cc}$ gelegt ist, in Reihe zwischen der n-Wannen-Spannung $U_{bn}$ und der p-Wannen-Spannung $U_{bp}$ angeordnet sind. Diese drei Transistoren realisieren den Entkoppelnegator 5.n, wobei die verbundenen Drains der Transistoren P5; N8 als Ausgang des Entkoppelnegators 5.n einen Knoten K3 bilden.

Dieser ist mit den Eingängen der vier Wortleitungsnegatoren 6.n.0...6.n.3 verbunden, die je einem der Wortleitungstakte TWL0...TWL3 zugeordnet und jeweils in Grundschaltung aus einem pMOS-Transistor P6 und einem nMOS-Transistor N10 ausgeführt sind. Dabei sind die Sourceanschlüsse der pMOS-Transistoren P6 jeweils mit einem der Wortleitungstakte TWL0... TWL3 verbunden; die Sourceanschlüsse der nMOS-Transistoren N10 liegen am Massepotential $U_{ss}$. Die verbundenen Gates sind am zugehörigen Knoten K3 angeschlossen. Die Drainverbindung jedes Transistorenpaares P6; N10 ist auf die zugehörige Wortleitung WLn.m geführt.

An die Bulkanschlüsse der pMOS-Transistoren P1; P2; P3; P5; P6 ist die n-Wannen-Spannung $U_{bn}$ und an die Bulkanschlüsse der nMOS-Transistoren N1...N10 ist die p-Wannen-Spannung $U_{bp}$ gelegt.

Nachstehend sei nunmehr die Funktionsweise der erfindungsgemäßen Schaltungsanordnung nach Fig. 2 beschrieben:
Als Ausgangszustand sollen die Wortadressen A2...A7 inaktiv sein, d. h. sie führen low-Pegel. Damit sind die Transistoren N5...N7 gesperrt.

Durch das low-aktive Rücksetzsignal RESET wird über den Transistor P4 die Source-Drain-Verbindung der Transistoren N1; N2, welche vorher das Potential der p-Wannen-Spannung $U_{bp}$ hatte, auf das Potential der Versorgungsspannung $U_{cc}$ geklemmt. Damit wird über den Transistor N1 der Knoten K2 auf ein Potential $U_{cc} - U_{tn}$ (mit $U_{tn}$ ... Schwellspannung des Transistors N1) aufgeladen. Um dies zu ermöglichen, muß die Impedanz des Transistors P4 wesentlich geringer sein als die des Transistors N2.

Mit dem Ansteigen des Potentials am Knoten K2 öffnen die Transistoren N3; NA und ziehen das Potential des Knotens K1 vom Wert der n-Wannen-Spannung $U_{bn}$ auf das Potential der p-Wannen-Spannung $U_{bp}$. Gleichzeitig sperrt der Transistor P3. Durch die Entladung des Knotens K1 öffnen die Transistoren P1; P2, so daß der Knoten K2 weiter aufgeladen wird. Wenn das Potential des Knotens K2 größer als $U_{cc} - U_{tn}$ wird, sperrt der Transistor N1 und verhindert damit, daß ein Querstrom fließt. Infolge des weiteren Aufladens des Knotens K2 wird die Impedanz des Transistors N4 noch geringer und die Transistoren P3 und N2 sperren sicher. Damit ist das Flipflop gekippt.

Der Knoten K3 als Ausgang des Entkoppelnegators 5.n führt danach high-Pegel, wodurch die Transistoren N10 in den angeschlossenen Wortleitungsnegatoren 6.n.m geöffnet sind und die Wortleitungen WL.n.m mit Massepotential $U_{ss}$ verbinden. Bei einer bestimmten, vorab programmierten Kombination der anliegenden Wortadressen A2...A7 wird die Drain-Source-Verbindung der Transistoren P1; P2 über die Transistoren N5...N7 entladen. Damit wird der Knoten K2 über den Transistor P2 entladen, so daß im weiteren der Transistor P3 öffnet und der Transistor N4 sperrt.

Der Knoten K1 wird aufgeladen und steuert den Transistor P1 zu sowie den Transistor N2 auf. Geringfügig zeitverzögert öffnet dann auch Transistor N1. Über die Transistoren N1; N2 wird nun der Knoten K2 auf das Potential der p-Wannen-Spannung $U_{bp}$ geklemmt und weiter entladen. Wenn das Potential des Knotens K2 kleiner als $U_{ss} - U_{tp}$ (mit $U_{tp}$ ... Schwellspannung des Transistors P2) wird, sperrt der Transistor P2 und verhindert das Fließen eines Querstromes.

Der Knoten K3, d. h. der Ausgang des Entkoppelnegators 5.n führt das Potential der p-Wannen-Spannung $U_{bp}$. Damit sind die Transistoren 10 der angewählten Gruppe von Wortleitungsnegatoren 6.n.0... 6.n.3 gesperrt und der jeweils aktivierte Wortleitungstakt TWLm lädt über den zugehörigen Transistor P6 die Wortleitung WL.n.m auf.

In den angesteuerten Wortleitungsnegatoren 6.n.m, bei denen der Wortleitungstakt TWLm nicht aktiviert ist, sind die entsprechenden Wortleitungen WL.n.m von den zugehörigen geöffneten Transistoren P6 über die Wortleitungstakte TWLm mit Massepotential $U_{ss}$ verbunden.

Dies tritt gleichfalls ein, wenn der Zugriff auf redundante Wortleitungen erfolgt und alle Wortleitungen WL.n.m auf low-Pegel bleiben.

Als Voraussetzung für die sichere Erdung nichtausgewählter Wortleitungen gilt
$U_{tp} > U_{bp} - U_{ss}$,
was als erfindungsgemäß gegeben ist.

Die erfindungsgemäße Schaltungsanordnung ist auch für den Fall einsetzbar, daß die n-Wannen-Spannung $U_{bn}$ gleich der Versorgungsspannung $U_{cc}$ ist, wie es in sRAM eingesetzt wird. Dabei vereinfacht sich die Ansteuerung des Adreßdekoders 1; die Entladung der Wortleitungen erfolgt wie vorstehend beschrieben.

**Patentansprüche**

1. Schaltungsanordnung zur Ansteuerung von Wortleitungen in Halbleiterspeichern mit einem Spannungsgenerator, an dessem Ausgang eine n-Wannen-Spannung bereitgestellt ist, einem zwischen der n-Wannen-Spannung und Massepotential angeordneten Wortleitungstaktdekoder mit m Eingängen, an welche erste Wortadressen des Halbleiterspeichers gelegt sind, und $2^m$ Ausgängen, an welchen Wortleitungstakte generiert sind, einem ebenfalls an der n-Wannen-Spannung angeschlossenen Adreßdekoder mit n Eingängen, auf welche zweite Wortadressen geführt sind, einem Rücksetzeingang sowie $2^n$ Ausgängen, und mit $2^n$ Gruppen zu je $2^m$ Wortleitungsnegatoren, deren Eingänge jeweils gruppenweise miteinander verbunden über jeweils einen mit einem Versorgungsspannungsanschluß an der n-Wannen-Spannung liegenden Entkoppelnegator an den Ausgängen des Adreßdekoders angeschlossen sind, wobei der jeweils erste Versorgungsspannungsanschluß jedes Wortleitungsnegators einer Gruppe mit einem der $2^m$ Ausgänge des Wortleitungstaktdekoders und die zweiten Versorgungsspannungsanschlüsse mit Massepotential verbunden sowie die Ausgänge der Wortleitungsnegatoren auf die $2^{m+n}$ Wortleitungen des Halbleiterspeichers geführt sind, dadurch gekennzeichnet, daß ein zweiter, zwischen Versorgungsspannung $(U_{cc})$ und Massepotential $(U_{ss})$ angeordneter Spannungsgenerator (4), dessen Ausgang eine gegenüber dem Massepotential $(U_{ss})$ verringerte p-Wannen-Spannung $(U_{bp})$ führt, vorgesehen, und daß diese p-Wannen-Spannung $(U_{bp})$ auf die jeweils zweiten Versorgungsspannungsanschlüsse des Adreßdekoders (1) sowie der Entkoppelnegatoren (5.i) gelegt ist.

2. Schaltungsanordnung nach Anspruch 1, dadurch gekennzeichnet, daß die p-Wannen-Spannung $(U_{bp})$ gegenüber dem Massepotential $(U_{ss})$ um zwei pMOS-Schwellspannungen $(U_{tp})$ verringert ist.

3. Schaltungsanordnung nach Anspruch 1, dadurch gekennzeichnet, daß die p-Wannen-Spannung $(U_{bp})$ gegenüber dem Massepotential $(U_{ss})$ um eine pMOS-Schwellspannung $(U_{tp})$ und weitere 0,5...1,0 V verringert ist.

4. Schaltungsanordnung nach einem der Ansprüche 1 bis 3, dadurch gekennzeichnet, daß die Versorgungsspannung $(U_{cc})$ und das Massepotential $(U_{ss})$ jeweils auf Referenzanschlüsse des Adreßdekoders (1) gelegt sind.

5. Schaltungsanordnung nach einem der Ansprüche 1 bis 4, dadurch gekennzeichnet, daß die Entkoppelnegatoren (5.i) aus zwei in Reihe geschalteten nMOS-Transistoren (N8; N9) mit einem weiteren in Reihe zu ihnen geschalteten pMOS-Transistor (P5) aufgebaut sind, wobei die verbundenen Gates des ersten nMOS- (N9) und des pMOS-Transistors (P5) den Eingang sowie die verbundenen Drains des zweiten nMOS- (N8) und des pMOS-Transistors (P5) den Ausgang des Entkoppelnegators (5.i) darstellen, und daß an das Gate des zweiten nMOS-Transistors (N8) die Versorgungsspannung $(U_{cc})$ gelegt ist.

6. Schaltungsanordnung nach einem der Ansprüche 1 bis 5, dadurch gekennzeichnet, daß die Versorgungsspannung $(U_{cc})$ und die n-Wannen-Spannung $(U_{bn})$ den gleichen Wert haben.

FIG.1

EP 0 498 252 A2

FIG.2